Europäisches Patentamt

(19) European Patent Office

Office européen des brevets

(11) Veröffentlichungsnummer : **0 021 204**
**B1**

(12) **EUROPÄISCHE PATENTSCHRIFT**

(45) Veröffentlichungstag der Patentschrift :
08.02.84

(21) Anmeldenummer : 80103172.5

(22) Anmeldetag : 09.06.80

(51) Int. Cl.³ : **H 01 J 27/02**, H 01 J 37/08

(54) **Ionengenerator.**

(30) Priorität : 29.06.79 US 53590

(43) Veröffentlichungstag der Anmeldung :
**07.01.81 Patentblatt 81/01**

(45) Bekanntmachung des Hinweises auf die Patenterteilung : **08.02.84 Patentblatt 84/06**

(84) Benannte Vertragsstaaten :
**DE FR GB**

(56) Entgegenhaltungen :
DE-A- 1 514 097
DE-A- 2 139 530
DE-A- 2 412 102
DE-B- 1 900 569
DE-B- 2 037 029
US-A- 3 233 404
US-A- 3 354 644
US-A- 3 364 075

(73) Patentinhaber : **International Business Machines Corporation**
**Old Orchard Road**
**Armonk, N.Y. 10504 (US)**

(72) Erfinder : **Chandrashekhar, G.V.**
**RD 4, Green Way Terrace**
**Mahopac, N.Y. 10541 (US)**
Erfinder : **Gambino, Richard Joseph**
**2433 Hunterbrook Road**
**Yorktown Heights, N.Y. 10598 (US)**
Erfinder : **Chaudhari, Praveen**
**416 Long Hill Road East**
**Briarcliff Manor, N.Y. 10562 (US)**
Erfinder : **Harper, James McKeel Edwin**
**507 Elizabeth Road**
**Yorktown Heights, N.Y. 10598 (US)**
Erfinder : **Cuomo, Jerome John**
**P.O. Box 353 Lovell Street**
**Lincolndale N.Y. 10540 (US)**

(74) Vertreter : **Rudack, Günter O., Dipl.-Ing.**
**c/o International Business Machines Corporation**
**Zurich Patent Operations Säumerstrasse 4**
**CH-8803 Rüschlikon (CH)**

Anmerkung : Innerhalb von neun Monaten nach der Bekanntmachung des Hinweises auf die Erteilung des
europäischen Patents im Europäischen Patentblatt kann jedermann beim Europäischen Patentamt gegen das erteilte
europäische Patent Einspruch einlegen. Der Einspruch ist schriftlich einzureichen und zu begründen. Er gilt erst als
eingelegt, wenn die Einspruchsgebühr entrichtet worden ist (Art. 99(1) Europäisches Patentübereinkommen).

Jouve, 18, rue St-Denis, 75001 Paris, France

**0 021 204**

Ionengenerator

Die Erfindung betrifft einen Ionengenerator zum Freisetzen von Ionen aus einem ionisierbaren Material für das Beaufschlagen eines Targets, in einer Vakuumkammer. Es wird damit ein Ionenfluss grosser Stromdichte erzeugt.

Als Ionenquellen werden häufig Plasmavorrichtungen benutzt. Das Plasma wird im allgemeinen durch die Wechselwirkung von Elektronen mit den Atomen eines Gases unter niedrigem Druck erzeugt. Ein elektrisches Feld dient dazu, Ionen aus dem Plasma abzuziehen und gegen die Oberfläche eines zu bombardierenden Zieles zu beschleunigen. Mit diesem Verfahren kann man Ionenströme hoher Intensität erhalten. Das gilt jedoch nur für Strahlenbündel mit geringem Durchmesser. Wird die beaufschlagte Oberfläche und damit der Strahldurchmesser vergrössert, so sinkt die Stromdichte entsprechend ab. Ein weiterer Nachteil von Plasmavorrichtungen besteht darin, dass die kinetische Energie der emittierten Ionen von Ion zu Ion variiert. Für viele Anwendungen ist eine solche Verbreiterung des Energiespektrums unerwünscht.

Oberflächenaktive Einrichtungen werden ebenfalls benutzt, um Ionenstrahlen zu erzeugen. Solche Einrichtungen setzen Ionen frei, wenn eine Flüssigkeit oder ein Gas längs einer aktiven Oberfläche fliesst, welche die Ionisation der Flüssigkeit oder des Gases fördert. Im allgemeinen erfordern solche Oberflächen eine erhöhte Temperatur, um Ionisation zu bewirken. Auch mögen sie die Aktivierung mittels eines Katalysators erfordern. Eine solche oberflächenaktive Einrichtung ist beispielsweise in der US Patentschrift 3 364 075 beschrieben. Aus gasförmigem Jod werden negative Ionen gebildet durch Kontakt mit einer Oberfläche aus Lanthanborid.

Als katalysierende Oberfläche verwendet man häufig Wolframwatte, deren aktivierende Oberfläche ein Gas ionisiert, wenn es den Wattepfropf durchfliesst. Eine Ionisiereinrichtung, die einen Pfropf aus erhitzter Wolframwatte verwendet, ist beispielsweise in der US Patentschrift 3 354 644 beschrieben. Die Stromdichte von oberflächenaktiven Ionenquellen wird durch den Fluss des Gases begrenzt, das längs der aktivierten Oberfläche fliesst. Für durchlässige Pfropfen wie beispielsweise aus Wolframwatte ist der Durchfluss eine Funktion des Druckabfalls im porösen Material. Die Leistung einer solchen Ionenquelle ist daher durch die Druckdifferenz begrenzt, welche über dem porösen Material aufrecht erhalten werden kann. Solche oberflächenaktiven Einrichtungen sind daher auf Stromdichten begrenzt, die in der Nachbarschaft von 30 mA/cm$^2$ liegen.

Oberflächenaktive Einrichtungen können auch anstelle von porösen Materialien kapillare Röhren verwenden. In der US Patentschrift 3 233 404 ist eine Einrichtung mit einer kapillaren Röhre aus einem feuerfesten Metall beschrieben, die das durchfliessende Gas ionisiert. Um die Oberfläche der Kapillaren zu aktivieren, muss sie stark erhitzt werden. Es wird berichtet, dass eine Röhre aus Tantal von 10 mm Länge und 0,4 mm Durchmesser auf 2 100 °K erhitzt und gasförmiges Caesium hindurchgeleitet wird. Der erzeugte Ionenstrom hat eine Stromdichte in der Grössenordnung von 1 A/cm$^2$. Die Einrichtung erzeugt daher einen sehr intensiven Ionenstrom, der aber nur auf eine sehr begrenzte Fläche einwirkt. Es ist möglich, die bestrahlte Oberfläche dadurch zu vergrössern, dass man eine Anordnung von einer Vielzahl von Kapillaren gleichzeitig verwendet. Die Stromdichte ist jedoch nicht gleichmässig, weil die einzelnen Kapillaren voneinander durch einen endlichen Abstand getrennt sind. Auch ist es schwierig, alle Kapillaren gleichzeitig auf der gleichen Temperatur zu halten.

Auch bei dieser Art von Einrichtungen ist die Leistung durch den Druckabfall innerhalb der Kapillaren begrenzt. Diese Leistungsgrenze gilt daher sowohl für Einrichtungen mit porösen Pfropfen als auch solche mit Kapillaren.

Es ist eine Aufgabe der Erfindung, einen Ionengenerator zum Erzeugen eines Ionenstromes möglichst hoher Stromdichte anzugeben, die nicht solchen Einschränkungen wie oben beschrieben unterliegt.

Der Ionengenerator der eingangs genannten Art ist gemäss der Erfindung durch die Merkmale des Anspruches 1 gekennzeichnet.

Weitere Vorteile des erfindungsgemässen Ionengenerators bestehen darin, dass der gelieferte Ionenstrom und die kinetische Energie der erzeugten Ionen unabhängig voneinander über einen breiten Bereich einstellbar sind. Weiter sind die Unterschiede der kinetischen Energie von Ion zu Ion nicht stark verschieden. Das Energiespektrum ist daher sehr schmalbandig. Der erzeugte Ionenfluss ist weitgehend einheitlich und es bestehen nur wenige Einschränkungen bezüglich der Gestalt und des Platzbedarfs der Ionenquelle. Je nach seiner Auslegung kann der Ionengenerator positive oder negative Ionen erzeugen.

Die Erfindung wird im folgenden anhand von Ausführungsbeispielen mit Hilfe der Zeichnungen näher erläutert.

Figur 1 zeigt ein erstes Ausführungsbeispiel eines Ionengenerators für das Beaufschlagen eines Targets in einer Vakuumkammer.

Figur 2 zeigt ein zweites Ausführungsbeispiel eines erfindungsgemässen Ionengenerators.

Der Ionengenerator besitzt einen Vorratsraum, der das ionisierbare flüssige oder gasförmige Material enthält. Eine an den Vorratsbehälter grenzende Wand besteht aus einem Ionenleiter. Auf der einen Seite steht der Ionenleiter mit dem ionisierbaren Material in Kontakt. Die andere Seite ist auf das Target gerichtet. Weiterhin sind Mittel vorgesehen, um über den Ionenleiter eine elektrische Potentialdifferenz

2

wirksam werden zu lassen, wodurch ein elektrisches Feld aufgebaut wird, das den Ionenfluss erzeugt.

Wenn der Ionenstrom eine Auftreffplatte oder ein Target treffen soll, dann benutzt man die Ionenquelle zusammen mit einer Vakuumkammer. Die Ionenquelle besitzt einen Vorratsraum, der das zu ionisierende Material enthält. Unmittelbar benachbart befindet sich der Ionenleiter. Eine Seite des Ionenleiters steht mit dem zu ionisierenden Material in Kontakt. Die andere Seite grenzt an die Vakuumkammer. In einem gewissen Abstand befindet sich innerhalb der Vakuumkammer das Target. Eine Spannungsquelle dient dazu, ein elektrisches Feld durch den Ionenleiter hindurch aufrechtzuerhalten. Die Spannungsquelle ist mit einer Elektrode bei dem Vorratsraum verbunden, ihr anderer Anschluss ist mit dem Target verbunden. Die Potentialdifferenz zwischen beiden Elektroden bewirkt ein elektrisches Feld, welches die Ionen bei ihrem Durchgang durch den Ionenleiter und in dem Zwischenraum auf das Target hin beschleunigt.

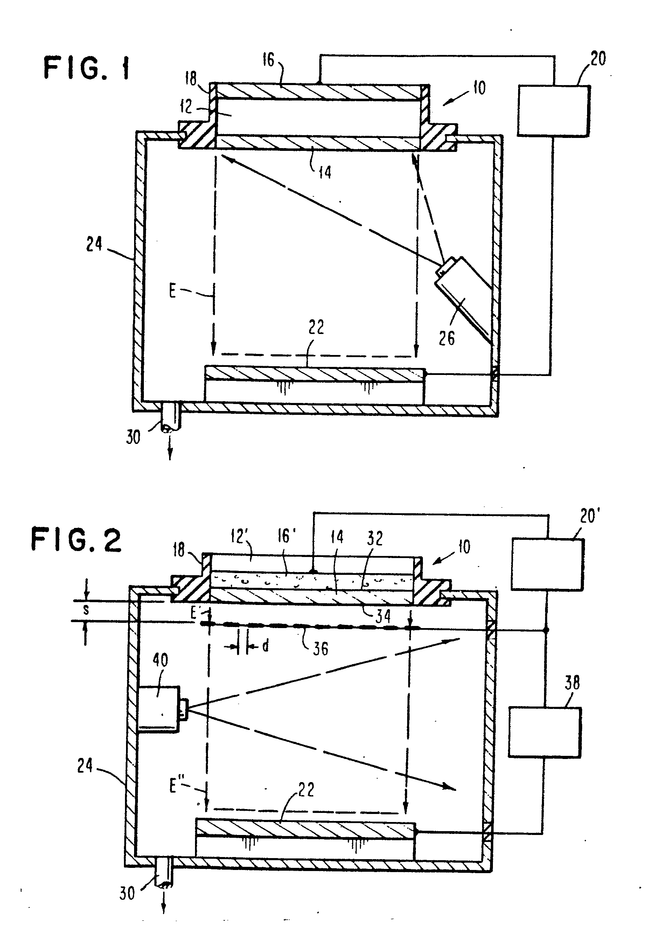

In der Fig. 1 besitzt der Ionengenerator 10 einen geschlossenen Vorratsraum 12, dessen Grundfläche durch einen Ionenleiter 14 und dessen Deckfläche durch eine Elektrode 16 gebildet wird. Die übrigen Begrenzungen des Vorratsraumes bestehen aus isolierenden Wänden 18. Dadurch können die Elektrode 16 und der Ionenleiter 14 auf verschiedenem Potential sein. Die Elektrode 16 kann aus einem Metall, einem Halbleiter oder aus einem Ionenleiter bestehen. Ein solcher Vorratsraum 12 ist geeignet, ein ionisierbares Medium im gasförmigen oder im flüssigen Zustand aufzunehmen. Der Ionenleiter 14 ist eine begrenzende Wand des Vorratsraumes 12, so dass der Ionenleiter mit dem ionisierbaren Material in Kontakt steht.

Für die Durchführung der Erfindung brauchbare Ionenleiter bestehen aus Festkörpern, welche die Elektrizität vorzugsweise durch den Transport von Ionen anstelle von Elektronen leiten. Ionen sind positiv oder negativ geladene Atome oder Moleküle, die eine elektrische Einheitsladung oder ein ganzzahliges Vielfaches davon tragen. Beispiele für geeignete Ionenleiter sind folgende : Einkristalle von Festkörpern wie $\beta$-Aluminiumoxid, in welchen der elektrische Strom durch eine Art von Ionen getragen wird, welche unter dem Einfluss eines elektrischen Feldes durch die kristalline Struktur wandern. Polykristalline Festkörper, welche die Elektrizität durch Ionentransport leiten entweder durch die Kristallkörner hindurch oder entlang den Korngrenzen. Amorphe, glasartige oder nichtkristalline Festkörper, welche den elektrischen Strom durch Ionentransport leiten. Oder poröse isolierende Körper, deren miteinander in Verbindung stehende Poren Flüssigkeiten wie geschmolzene Salze enthalten, welche die Elektrizität vorzugsweise durch den Transport von Ionen leiten.

Im letzteren Falle muss das Porenvolumen im Vergleich zum Festkörper klein genug sein, damit der Körper stabil genug ist, um Druckunterschieden in der Grösse von $10^5$ Pa standhalten zu können. Geeignet ist beispielsweise ein keramischer Körper mit einem Porenvolumen von weniger als 25 %.

Wenn ein durch den Ionenleiter hindurch wirksames elektrisches Feld E aufgebaut wird, werden die Ionen beschleunigt. Eine Spannungsquelle 20 wird an die Elektrode 16 und an das Target 22 angeschlossen, wodurch ein durch den Ionenleiter 14 hindurch wirkendes elektrisches Feld E aufrecht erhalten wird.

Damit Ionen von dem Ionenleiter 14 abgegeben werden können und um sicherzustellen, dass sie auf dem Wege zum Target 22 nicht gebremst oder abgefangen werden, wird das Target 22 in einer Vakuumkammer 24 angeordnet, die auch mit dem Ionengenerator 10 in Verbindung steht. Vorzugsweise ist der Druck in der Vakuumkammer 24 kleiner als $10^{-1}$ Pa. Dann findet eine Feldemission von dem Ionenleiter 14 her statt und ein Ionenfluss hoher Dichte fällt auf das Target 22 ein.

Durch Beschiessen der Oberfläche des Ionenleiters 14 mit Ionen von einer zusätzlichen Plasmaquelle 26 kann der Fluss der durch den Ionengenerator 10 gelieferten Ionen wesentlich verstärkt werden. Die Ausbeute an Ionen von dem Ionenleiter 14 wird durch das zusätzliche Ionenbombardement erhöht. Bei diesem Verfahren wird durch die von der Plasmaquelle 26 eingeführten Ionen der Druck in der Vakuumkammer erhöht. Um diesen Druckanstieg unter Kontrolle zu halten, muss man die Vakuumkammer 24 fortlaufend über die Auslassöffnung 30 abpumpen.

In der Fig. 2 ist ein zweites Ausführungsbeispiel der Erfindung dargestellt. Der Ionengenerator 10 arbeitet mit einer Flüssigkeit, welche das zu ionisierende Material enthält. Der Vorratsraum 12' enthält eine Flüssigkeit und mag daher wie in der Fig. 2 dargestellt als offene Schale ausgebildet sein. Der Ionenleiter 14 bildet eine der Wände des Vorratsraums. Die übrigen Wände 18 sind vorzugsweise isolierend. Die Deckfläche 32 des Ionenleiters 14 steht mit dem zu ionisierenden Material in Kontakt. Seine Unterfläche 34 ist gegen die Vakuumkammer 24 und damit gegen das Target 22 gerichtet.

Eine erste Elektrode 16' kontaktiert das zu ionisierende Material. Wenn die Elektrode 16' aus einem porösen Material besteht, kann sie gleichzeitig mit dem Ionenleiter in Kontakt stehen und so dem ionisierbaren Material erlauben, in den Ionenleiter 14 hinein zu diffundieren. Die Elektrode kann andererseits auch vom Ionenleiter 14 entfernt angeordnet sein wie die Elektrode 16 in der Fig. 1.

Wenn der Ionenleiter beispielsweise $ZrO_2$ ist, das mit CaO oder $Y_2O_3$ stabilisiert ist und der Vorratsbehälter 12 gasförmiges $O_2$ enthält, dann verbessert eine Elektrode aus porösem Platin an der $ZrO_2/O_2$-Grenzschicht den Ladungstransport durch den Ionenleiter 14.

Eine zweite Elektrode 36 ist getrennt, jedoch dicht benachbart zur Unterfläche 34 des Ionenleiters 14 angeordnet. Vorzugsweise besteht die zweite Elektrode 36 aus einem Drahtgitter, dessen Maschenweite d klein im Vergleich zum Abstand s zwischen der zweiten Elektrode 36 und dem Ionenleiter 14 ist. Eine erste Spannungsquelle 20' unterhält eine Potentialdifferenz zwischen der zweiten Elektrode 36 und der ersten Elektrode 16'. Diese Potentialdifferenz bewirkt ein elektrisches Feld E' durch den Ionenleiter 14 hindurch. Die Polarität der Spannungsquelle hängt davon ab, ob positive oder negative Ionen durch den Ionenleiter 14 hindurch diffundieren sollen.

Eine zweite Spannungsquelle 38 unterhält eine Potentialdifferenz zwischen der zweiten Elektrode 36 und dem Target 22. Dadurch wird ein zusätzliches elektrisches Feld E'' erzeugt. Wenn das Feld E' und das Zusatzfeld E'' von gleicher Polarität sind, dann beschleunigt das Zusatzfeld E'' die von der zweiten Elektrode 36 herkommenden Ionen weiter in Richtung auf das Target 22.

Der mit der Anordnung nach der Fig. 2 erzeugte Ionenstrom ist sehr stark, so dass die gleichnamigen Ladungen der transportierten Ionen eine Raumladung hervorrufen können, welche eine Divergenz des Strahles bewirkt. Um eine solche Strahldivergenz zu verhindern, werden vorzugsweise Mittel eingesetzt, um die Raumladungen zu neutralisieren. Das kann beispielsweise eine Hohlkathode 40 sein, wie sie durch H. R. Kaufmann in « Advances In Electronics And Electron Physics », *36*, 265 (1974) beschrieben ist. Zum Neutralisieren der Raumladungen können auch andere Mittel eingesetzt sein wie beispielsweise eine Glühkathode.

Zum Fördern des Verständnisses dafür, welche Stromdichten mit dem beschriebenen Ionengenerator erreicht werden können, wurden Versuche ausgeführt, wobei als Ionenleiter $Na^+$ β-Aluminiumoxid und als Natriumquelle eine eutektische Schmelze von $NaNO_3$ und $NaNO_2$ verwendet wurden. Eine mit der eutektischen Schmelze getränkte Fibermatte diente als Vorrat für das zu ionisierende Material. Diese Matte stand auf der einen Seite mit einem $Na^+$ β-Aluminiumoxid-Kristall und einer Goldelektrode in Kontakt. Im Abstand von 3,5 mm war eine zweite Goldelektrode auf der anderen Seite des Ionenleiters angeordnet. Die Elektroden, der Ionenleiter und die durchtränkte Fibermatte waren in einem Gefäss untergebracht, das auf etwa $10^{-1}$ bis $10^{-2}$ Pa evakuiert und mittels einer Heizvorrichtung auf 300 °C erhitzt war. Die mit der eutektischen Schmelze in Kontakt stehende Elektrode befand sich auf dem höheren Potential. Unter diesen Bedingungen wurde eine Stromdichte von 100 mA/cm² erhalten. Diese Stromdichte liegt wesentlich höher als der Wert von 30 mA/cm², der mit Ionenquellen erreicht wird, die poröse Pfropfen wie beispielsweise Wolframwatte verwenden.

Bei diesen Versuchen wurden positive Natriumionen erzeugt. Je nach der Art der Ionen, die man erhalten will, können auch andere Materialien für den Ionenleiter und die Vorratsquelle verwendet werden.

Das folgende Prüfverfahren kann verwendet werden, um festzustellen, ob ein Material als Ionenleiter für den erfindungsgemässen Ionengenerator geeignet ist. Das zu untersuchende Material wird in eine geeignete flache Form gebracht mit parallelen Deckflächen und Unterflächen. Eine Flüssigkeit oder ein Gas, welches das zu ionisierende Material enthält, wird mit einer der beiden Seiten des zu untersuchenden Materials für den Ionenleiter in Kontakt gebracht. Zwei chemisch inerte Elektroden wie beispielsweise Goldblätter werden für die Versuche benutzt. Eine erste Elektrode kontaktiert eine der Oberflächen des Materials. Die zweite Elektrode steht mit der Flüssigkeit oder dem Gas in Kontakt. Durch Anlegen einer Spannung an die Elektroden wird ein elektrisches Feld in dem Testmaterial zur Wirkung gebracht. Der während des Versuchs fliessende Strom und die Zeit werden gemessen, der Stromfluss wird in Abhängigkeit von der Zeit registriert. Am Ende des Versuches wird das elektrische Feld abgeschaltet und man misst die Zahl der Grammäquivalente des von der Ionenquelle zu der Elektrode auf der anderen Seite transportierten Materials.

Mann kann einen Qualitätsfaktor R des Materials bestimmen, indem man die Anzahl der transportierten Grammäquivalente durch die Anzahl von Faradays dividiert, welche das Testmaterial durchliefen. Die Anzahl der Faradays ist der Strom in Ampere (Coulomb je Sekunde) multipliziert mit der Zeit in Sekunden, während der der Strom floss, und dividiert durch $9,6 \times 10^4$. Wenn R dicht bei eins liegt, ist das untersuchte Material ein Ionenleiter, d. h. der elektrische Strom durch das Material wird vorzugsweise von Ionen getragen. Für die Erfindung ist ein Material als Ionenleiter bereits brauchbar, wenn dieser Faktor R grösser als 0,2 ist.

Wenn der Querschnitt des Testmaterials bekannt ist, kann auch die Ionenstromdichte J bestimmt werden. Der Wert J ist das Produkt des Faktors R mal den Strom, dividiert durch den Querschnitt. Ein brauchbarer Ionenleiter ist einer, der einen Ionenfluss von mindestens $10^{15}$ Ionen je cm² in der Sekunde ermöglicht. Für die Einheitsladung tragende Ionen entspricht das einem Wert J der Stromdichte von mindestens $1,6 \times 10^{-4}$ A/cm². Die Werte von sowohl R als auch J sind stark von der Temperatur abhängig, so dass beispielsweise ein Material ein brauchbarer Ionenleiter bei einer erhöhten Temperatur sein kann, aber nicht bei Raumtemperatur.

In der Tabelle I sind einige Ionenleiter aufgeführt, die für den erfindungsgemässen Ionengenerator geeignet sind.

Tabelle I

Ionenquellen mit Ionenleitern

| Ion | Ionenleiter | Leitfähigkeit $(Ohm\ cm)^{-1}$ | Arbeits-temperatur °C | Inhalt des Vorrats |
|---|---|---|---|---|
| $O^-$ | $ZrO_2$ $(Y_2O_3$ stabilisiert) | $7.6 \times 10^{-2}$ | 1000 | $O_2$ Gas mit poröser Pt-Elektrode |
| $Li^+$ | $Li_3N$ | $1.5 \times 10^{-1}$ | 450 | Li Metall-schmelze |
| | LiOH | $10^{-2}$ | 400 | Li Metall-schmelze |
| $F^-$ | $KBiF_4$ | $4 \times 10^{-3}$ | 100 | $KHF_2$ Schmelze |
| | | $2 \times 10^{-1}$ | 300 | |
| $J^-$ | $KAg_3J_4$ | $\sim 10^{-2}$ | $\sim 100$ | $KJ-J_2$ eutektisch |
| $Na^+$ | $Na^+$ β -Aluminiumoxid | $2 \times 10^{-1}$ | 300 | $NaNO_3-NaNO_2$ eutektisch |

Jede der in der Tabelle aufgeführten Ionenquellen hat ihre spezielle Anwendung, abhängig von den Ionen, die erzeugt werden. Die Anwendung mag auch von dem verfolgten Zweck abhängen, was mit dem Ionenbombardement erfolgen soll, und von der Natur und der Zusammensetzung des Targetmaterials. Beispielsweise ist $O^-$ ein sehr reaktionsfähiges Ion. Wenn es dazu gebraucht wird, ein Metall zu beschiessen wie Al, Ta, Nb, Pb oder einen Halbleiter wie Si, Ge oder GaAs, kann man eine Oxidschicht auf diesen Materialien bilden. Solche Schichten können dem Korrosionsschutz dienen oder als elektrische Isolierschichten. Wenn das Targetmaterial flüchtige Oxide bildet wie beispielsweise Kohlenstoff, der unter Beschiessung mit $O^-$ Ionen CO und $CO_2$ bildet, dann kann der Ionenstrahl mit Sauerstoffionen für Ionen-unterstütztes chemisches Aetzen (IACE) verwendet werden. Beispielsweise können organische Verbindungen oder andere kohlehaltige Reste von Oxidsubstraten durch Beschiessen mit $O^-$ Ionen entfernt werden.

Eine weitere Anwendungsmöglichkeit für das Beschiessen mit Ionen ist das Dotieren von Halbleitern durch Ionenimplantation. Ein für ein solches Verfahren gebrauchtes Ion muss fähig sein, die elektrischen Eigenschaften des das Target bildenden Halbleiters verändern zu können. Beispielsweise kann Li in Si implantiert werden, um dessen Leitfähigkeit zu verbessern. Ein Vorzug des einen Ionenleiter verwendenden Ionengenerators besteht darin, dass Ionen sehr geringer Energie verwendet werden können, um sehr flache Implantationen für das Dotieren von Oberflächen zu bilden. Auch wird nur das gewünschte Dotierungsmaterial implantiert, weil der verwendete Ionenleiter sehr selektiv in der Auswahl der zu leitenden Ionen ist. Unerwünschte Dotierungsstoffe werden daher vom Ionenleiter nicht transportiert sondern vielmehr zurückgewiesen.

Für einige Anwendungen des Ionen-unterstützten chemischen Aetzens ist $F^-$ ein besonders wirksames Ion. Beispielsweise bildet Silizium unter der Beschiessung mit Fluorionen ein flüchtiges Fluorid $SiF_4$. Unter Beschiessung mit $F^-$ Ionen wird Silizium sehr schnell geätzt. Bei der Herstellung von Halbleitervorrichtungen mit Silizium ist es oft notwendig, Silizium aus speziell gewählten Gebieten zu entfernen, ohne andere Gebiete oder Teile der Vorrichtung zu beschädigen. Die hohe Aetzrate von Si in einem Strahl von $F^-$ Ionen kann ausgenutzt werden, nur solche Teile der Vorrichtung abzuätzen, wo das Silizium dem Strahl ausgesetzt wird.

Einige Verfahren für die Herstellung von durchlässigen plastischen Filmen benötigen die Erzeugung von Störstellen durch den Einschlag schwerer Ionen im Material. Die durch den Einschlag von schweren Ionen geschädigten Gebiete werden anschliessend durch selektives chemisches Aetzen entfernt, und bilden so die Durchlasskanäle durch die Kunststoffschicht. Solche Filme können als Mikrofilter gebraucht werden. Ein für ein solches Verfahren geeignetes schweres Ion ist beispielsweise das $J^-$ Ion, das von einer Ionenquelle mit dem Ionenleiter $KAg_3J_4$ geliefert wird.

Ionen mit geringer Elektronegativität wie beispielsweise $Na^+$ können dazu verwendet werden, mit hoher Ausbeute negative Ionen zu produzieren, die in einem Oberflächenuntersuchungsverfahren durch Massenspektroskopie mit Sekundärionen (SIMS) gebraucht werden. Bei der Analyse von gewissen Elementen als Konstituenten einer zu untersuchenden Probe kann die Detektionsempfindlichkeit sehr gering sein, wenn beispielsweise bei Beschiessen mit $Ar^+$ oder $O_2^+$ Ionen die Ionenausbeute sehr gering ist. Wenn man jedoch einen Strahl von $Na^+$ Ionen verwendet, kann die Empfindlichkeit für das Aufspüren solcher Elemente erheblich verbessert werden, weil $Na^+$ eine hohe Ausbeute an negativen Ionen ergibt, die im Massenspektrograph nachgewiesen werden können.

Der beschriebene Ionengenerator ist für eine ganze Reihe von industriellen Anwendungen geeignet. Dazu gehört die Halbleiterindustrie, die materialverarbeitende Industrie und der Bereich der Materialprüfung.

Bei Anwendungen in der elektronischen Industrie, insbesondere bei der Halbleiterherstellung, werden Ionenquellen für Kathoden-Aufsprühverfahren und für durch Ionenstrahlung unterstützte abtragende Bearbeitungsverfahren, auch chemischer Art verwendet. Weiter werden in der Halbleitertechnik Ionenstrahlen für Ionenimplantation gebraucht, für das Dotieren von Halbleitern und für das Anbringen von selektiven Oberflächenveränderungen, um beispielsweise elektronische Schaltungen zu verändern oder für bestimmte Zwecke anzupassen.

Die materialverarbeitende Industrie benutzt Ionenstrahlen zum Behandeln von Schichten von Kunststoffen, um beispielsweise Mikrofilter herzustellen. Auch kann man die Oberflächen von Metallen durch Bombardierung mit Ionen behandeln, um an der Oberfläche eine amorphe Schicht herzustellen, wodurch beispielsweise die Korrosionsfestigkeit verbessert wird. Auch kann die Implantation von Ionen dazu verwendet werden, die chemische Zusammensetzung der Oberfläche zu verändern und so auch die physikalischen Eigenschaften des Materials zu ändern.

Im Bereich der Materialprüfung verwendet man Ionenstrahlen, um selektiv Schichten an der Oberfläche abzutragen und das Material zu analysieren. Die Schichten können dann einzeln studiert werden.

## Ansprüche

1. Ionengenerator zum Freisetzen von Ionen aus einem ionisierbaren Material für das Beaufschlagen eines Targets in einer Vakuumkammer (24), indem ein das ionisierbare, flüssige oder gasförmige Material enthaltender Vorratsraum (12) und eine auf der einen Seite mit dem ionisierbaren Material in Kontakt stehende, aus einem Ionenleiter (14) bestehende und an den Vorratsraum grenzende Wand, deren andere Seite auf das Target (22) gerichtet ist, vorgesehen sind, dadurch gekennzeichnet, dass Mittel (16, 20, 22) vorgesehen sind, um über den genannten Ionenleiter eine elektrische Potentialdifferenz wirksam werden zu lassen, wodurch ein elektrisches Feld aufgebaut wird, das den Ionenfluss erzeugt.

2. Ionengenerator nach Anspruch 1, dadurch gekennzeichnet, dass eine Heizvorrichtung für die Ionenquelle vorgesehen ist.

3. Ionengenerator nach Anspruch 1, dadurch gekennzeichnet, dass eine Elektrode (16) vorgesehen ist, die mit dem ionisierbaren Material im Vorratsraum (12) in Kontakt steht, und dass eine Spannungsquelle (20) vorgesehen ist, die an die genannte Elektrode (16) und an das Target (22) angeschlossen ist.

4. Ionengenerator nach Anspruch 3, dadurch gekennzeichnet, dass eine zweite Elektrode (36) im Raum zwischen der Unterfläche (34) des Ionenleiters (14) und dem Target (22) angeordnet ist, dass eine erste Spannungsquelle (20') an die erste Elektrode (16') und die zweite Elektrode (36) angeschlossen ist, und dass eine zweite Spannungsquelle (38) vorgesehen ist, die an die genannte zweite Elektrode (36) und das Target (22) angeschlossen ist.

5. Ionengenerator nach Anspruch 1, dadurch gekennzeichnet, dass in der Vakuumkammer (24) eine zusätzliche Plasmaquelle (26) angeordnet ist, deren Ionenbeschuss der Unterseite des Ionenleiters (14) die Diffusion von Ionen durch den Ionenleiter hindurch verbessert.

6. Ionengenerator nach Anspruch 1, dadurch gekennzeichnet, dass innerhalb der Vakuumkammer (24) Mittel zur Kompensation der Raumladung vorgesehen sind.

7. Ionengenerator nach Anspruch 6, dadurch gekennzeichnet, dass eine Hohlkathode (40) innerhalb der Vakuumkammer angeordnet ist.

8. Ionengenerator nach Anspruch 6, dadurch gekennzeichnet, dass eine Glühkathode innerhalb der Vakuumkammer angeordnet ist.

9. Ionengenerator nach Anspruch 1, dadurch gekennzeichnet, dass der Ionenleiter (14) ein Einkristall aus $Na^+$ β-Aluminiumoxid ist und dass der Vorratsbehälter (12) eine eutektische Schmelze von Natriumnitrat und Natriumnitrit ($NaNO_3$-$NaNO_2$) enthält.

**Claims**

1. Ion generator for producing ions from an ionizable material for bombarding a target in a vacuum chamber (24), having a reservoir (12) which contains the ionizable, liquid or gaseous material, and a wall adjacent to the reservoir and consisting of an ion conductor (14), and with its one side contacting the ionizable material, its other side being directed to the target (22), characterized in that means (16, 20, 22) are provided for creating an electrical potential difference across said ion conductor, thereby providing an electric field which generates the ion flux.

2. Ion generator according to claim 1, characterized in that means for heating the ion source are provided.

3. Ion generator according to claim 1, characterized in that an electrode (16) is provided in contact with the ionizable material within the reservoir (12), and that a voltage source is provided which is connected to said electrode (16) and to the target (22).

4. Ion generator according to claim 3, characterized in that a second electrode (36) is arranged in the space between the lower surface (34) of the ion conductor (14) and the target (22), and that a first voltage source (20') is connected to the first electrode (16') and to the second electrode (36), and that a second voltage source (38) is provided which is connected to said second electrode (36) and to the target (22).

5. Ion generator according to claim 1, characterized in that inside the vacuum chamber (24) there is arranged an additional plasma source (26), the ion bombardment of the lower surface of the ion conductor (14) by which enhances the diffusion of ions through the ion conductor.

6. Ion generator according to claim 1, characterized in that inside the vacuum chamber (24) means are provided for compensating the space charge.

7. Ion generator according to claim 6, characterized in that a hollow cathode (40) is arranged inside the vacuum chamber.

8. Ion generator according to claim 6, characterized in that a thermionic filament is arranged inside the vacuum chamber.

9. Ion generator according to claim 1, characterized in that the ion conductor (14) is a $Na^+$ β-alumina single crystal and that the reservoir (12) contains an eutectic melt of sodium nitrate and sodium nitrite ($NaNO_3$-$NaNO_2$).

**Revendications**

1. Générateur d'ions pour libérer des ions d'une substance ionisable, en vue de bombarder une cible dans une enceinte sous vide (24), une chambre d'alimentation (12) étant prévue pour contenir la substance ionisable, liquide ou gazeuse, et comportant une cloison de séparation ayant une face en contact avec la substance ionisable, et l'autre face en regard de la cible (22), cette cloison de séparation étant constituée d'un matériau conducteur d'ions (14) et limitant la chambre d'alimentation ; le générateur étant caractérisé en ce qu'il comporte des moyens (16, 20, 22) pour mettre en jeu une différence de potentiel électrique de part et d'autre du conducteur d'ions précité, afin d'établir un champ électrique pour provoquer le flux ionique.

2. Générateur conforme à la revendication 1, caractérisé en ce qu'il comporte un dispositif de chauffage pour la source d'ions.

3. Générateur conforme à la revendication 1, caractérisé en ce qu'il comporte une électrode (16) qui se trouve en contact avec la substance ionisable dans la chambre d'alimentation (12), et une source de tension (20) raccordée à l'électrode précitée (16) et à la cible (22).

4. Générateur conforme à la revendication 3, caractérisé en ce qu'il comporte une seconde électrode (36) disposée dans l'espace existant entre la face inférieure (34) du conducteur d'ions (14) et la cible (22), une première source de tension (20') étant raccordée à la première électrode (16') et à la seconde électrode (36), et une seconde source de tension (38) étant en outre raccordée à ladite seconde électrode (36) et à la cible (22).

5. Générateur selon la revendication 1, caractérisé en ce qu'il comporte en outre une source de plasma (26), disposée dans l'enceinte sous vide (24), de telle manière que le bombardement ionique de cette source de plasma (22) sur la face inférieure du conducteur d'ions (14) améliore la diffusion des ions à travers le conducteur ionique.

6. Générateur conforme à la revendication 1, caractérisé en ce qu'il comporte des moyens disposés dans l'enceinte sous vide (24) pour compenser la charge d'espace.

7. Générateur conforme à la revendication 6, caractérisé en ce qu'il comporte une cathode creuse (40), disposée à l'intérieur de l'enceinte sous vide.

8. Générateur conforme à la revendication 6, caractérisé en ce qu'il comporte une cathode à effet thermo-ionique disposée à l'intérieur de l'enceinte sous vide.

9. Générateur conforme à la revendication 1, caractérisé en ce que le conducteur d'ions (14) est un monocristal d'oxyde d'aluminium et de $Na^+$ β ; et en ce que le réservoir d'alimentation (12) contient un mélange eutectique fondu de nitrate de sodium et de nitrite de sodium ($NaNO_3$-$NaNO_2$).

FIG. 1

FIG. 2